# EUROPEAN PATENT APPLICATION

(11) **EP 4 608 111 A1**
(43) Date of publication of application: **27.08.2025**
(21) Application number: 23893552.2
(22) Date of filing: 30.10.2023
(51) Int. Cl.: H10K 59/40

(54) **FLEXIBLE DISPLAY PANEL AND ELECTRONIC DEVICE**

(30) Priority: 24.11.2022 CN 202223168897 U
(71) Applicant: Huawei Technologies Co., Ltd., Shenzhen, Guangdong 518129 (CN)
(72) Inventor: LIU, Guohe, Shenzhen, Guangdong 518129 (CN); LUO, Jiajia, Shenzhen, Guangdong 518129 (CN); ZHANG, Junyong, Shenzhen, Guangdong 518129 (CN); HE, Hu, Shenzhen, Guangdong 518129 (CN)
(74) Representative: MERH-IP Matias Erny Reichl Hoffmann Patentanwälte PartG mbB
(86) International application number: PCT/CN2023/127683
(87) International publication number: WO 2024/109461

(57) **Abstract**

This application provides a flexible display panel and an electronic device. The flexible display panel includes a plurality of OLED devices, an encapsulation layer, and a plurality of color filter layers. The color filter layer may be located above the encapsulation layer or inside the encapsulation layer. A projection of each OLED device in a thickness direction of the flexible display panel overlaps one of the color filter layers. Each color filter layer is configured to transmit light emitted by an OLED device corresponding to the color filter layer. In this application, a position of the color filter layer is designed, so that a spacing between the OLED device and the color filter layer is small, thereby resolving problems of optical viewing angle color shift and viewing angle brightness attenuation, and improving display effect.

## Description

This application claims priority to Chinese Patent Application No. 202223168897.8, filed with the China National Intellectual Property Administration on November 24, 2022, and entitled "FLEXIBLE DISPLAY PANEL AND ELECTRONIC DEVICE", which is incorporated herein by reference in its entirety.

### TECHNICAL FIELD

This application relates to the field of electronic products, and specifically, to a flexible display panel and an electronic device.

### BACKGROUND

An organic material may be used for stacked layers of a flexible AMOLED (active-matrix organic light-emitting diode, active-matrix organic light-emitting diode) display. Based on a good deformation resistance capability of the organic material, the flexible AMOLED display may have good bending resistance performance, and can be better suitable for a screen bending scenario. However, a conventional flexible AMOLED display has problems of optical viewing angle color shift and viewing angle brightness attenuation, which affect display effect.

### SUMMARY

This application provides a flexible display panel and an electronic device, to resolve problems of optical viewing angle color shift and viewing angle brightness attenuation, and improve display effect.

According to a first aspect, this application provides a flexible display panel. The flexible display panel includes a plurality of OLED devices, an encapsulation layer, an organic layer, a plurality of color filter layers, and a first black matrix. The encapsulation layer covers the plurality of OLED devices. The organic layer covers the encapsulation layer, and a quantity of organic layers is less than 3. The plurality of color filter layers and the first black matrix are all formed on the organic layer. Two adjacent color filter layers are separated by the first black matrix. A projection of each OLED device in a thickness direction of the flexible display panel overlaps one of the color filter layers. Each color filter layer is configured to transmit light emitted by an OLED device corresponding to the color filter layer.

In this solution, there are fewer than three layers of the organic layer between the color filter layer and the OLED device. In this way, in comparison with a conventional flexible display panel, a spacing between the color filter layer and the OLED device can be reduced, so that a light exit angle of the OLED device is large. This helps increase a visible angle of the display panel, and therefore can resolve problems of optical viewing angle color shift and viewing angle brightness attenuation. Therefore, compared with an image viewed by a user at a position facing a center of a screen, an image viewed on a side of a display does not have an obvious color difference and obvious brightness attenuation.

In an implementation of the first aspect, the flexible display panel includes a first touch layer and a second touch layer. The quantity of organic layers is 2. The organic layers include a first organic layer and a second organic layer. The first organic layer covers the encapsulation layer. The second organic layer covers the first organic layer and the first touch layer. The second touch layer, the plurality of color filter layers, and the first black matrix are all formed on the second organic layer, and the first black matrix covers the second touch layer.

In this solution, there are only two layers of the organic layer between the color filter layer and the OLED device. In this way, in comparison with a conventional flexible display panel, a spacing between the color filter layer and the OLED device can be reduced, so that a light exit angle of the OLED device is large. This helps increase a visible angle of the display panel, and therefore can resolve problems of optical viewing angle color shift and viewing angle brightness attenuation. Therefore, compared with an image viewed by a user at a position facing a center of a screen, an image viewed on a side of a display does not have an obvious color difference and obvious brightness attenuation.

In an implementation of the first aspect, the first touch layer is formed on the first organic layer. In this solution, the first touch layer is formed on the first organic layer, so that a product requirement can be met.

In an implementation of the first aspect, the flexible display panel includes a second black matrix. The second black matrix is formed on the encapsulation layer. The first organic layer further covers the second black matrix. A projection of the first black matrix in the thickness direction of the flexible display panel overlaps the second black matrix. In this solution, the black matrix can absorb ambient light and reduce reflectivity of the display panel. Two layers of black matrices are designed, so that the reflectivity of the display panel can be enhanced, and display performance of the display panel can be improved.

In an implementation of the first aspect, the flexible display panel includes a second black matrix. The second black matrix is formed on the first organic layer. The first touch layer is formed on the second black matrix. The second organic layer further covers the second black matrix. In this solution, the black matrix can absorb ambient light and reduce reflectivity of the display panel. Two layers of black matrices are designed, so that the reflectivity of the display panel can be enhanced, and display performance of the display panel can be improved.

In an implementation of the first aspect, the quantity of organic layers is 1. The flexible display panel includes a second black matrix, a first touch layer, and a second touch layer. The second black matrix is formed on the encapsulation layer. The first touch layer is formed on the second black matrix. The organic layer further covers the second black matrix and the first touch layer. The second touch layer is formed on the organic layer. The first black matrix covers the second touch layer. A projection of the first black matrix in the thickness direction of the flexible display panel overlaps the second black matrix.

In this solution, there is only one layer of the organic layer between the color filter layer and the OLED device. In this way, in comparison with a conventional flexible display panel, a spacing between the color filter layer and the OLED device can be reduced, so that a light exit angle of the OLED device is large. This helps increase a visible angle of the display panel, and therefore can resolve problems of optical viewing angle color shift and viewing angle brightness attenuation. Therefore, compared with an image viewed by a user at a position facing a center of a screen, an image viewed on a side of a display does not have an obvious color difference and obvious brightness attenuation. In addition, two layers of black matrices are designed, so that reflectivity of the display panel can be enhanced, and display performance of the display panel can be improved.

In an implementation of the first aspect, the quantity of organic layers is 1. The flexible display panel includes a second black matrix and a first touch layer. The second black matrix is formed on the encapsulation layer. The first touch layer is formed on the second black matrix. The organic layer further covers the second black matrix and the first touch layer. A projection of the first black matrix in the thickness direction of the flexible display panel overlaps the second black matrix. The first black matrix is used as a second touch layer.

In this solution, there is only one layer of the organic layer between the color filter layer and the OLED device. In this way, in comparison with a conventional flexible display panel, a spacing between the color filter layer and the OLED device can be reduced, so that a light exit angle of the OLED device is large. This helps increase a visible angle of the display panel, and therefore can resolve problems of optical viewing angle color shift and viewing angle brightness attenuation. Therefore, compared with an image viewed by a user at a position facing a center of a screen, an image viewed on a side of a display does not have an obvious color difference and obvious brightness attenuation. In addition, the first black matrix and the second black matrix are designed, so that reflectivity of the display panel can be enhanced, and display performance of the display panel can be improved. In addition, the second black matrix has functions of both a black matrix and a touch layer, so that stacked layers of the panel can be reduced, a fabrication process can be simplified, and costs can be reduced.

According to a second aspect, this application provides a flexible display panel. The flexible display panel includes a plurality of OLED devices, an encapsulation layer, a plurality of color filter layers, and a first black matrix. The encapsulation layer covers the plurality of OLED devices. The plurality of color filter layers and the first black matrix are all formed on the encapsulation layer. Two adjacent color filter layers are separated by the first black matrix. A projection of each OLED device in a thickness direction of the flexible display panel overlaps one of the color filter layers. Each color filter layer is configured to transmit light emitted by an OLED device corresponding to the color filter layer.

In this solution, the color filter layer is fabricated on the encapsulation layer. In this way, in comparison with a conventional flexible display panel, a spacing between the color filter layer and the OLED device can be greatly reduced, so that a light exit angle of the OLED device is large. This helps increase a visible angle of the display panel, and therefore can resolve problems of optical viewing angle color shift and viewing angle brightness attenuation. Therefore, compared with an image viewed by a user at a position facing a center of a screen, an image viewed on a side of a display does not have an obvious color difference and obvious brightness attenuation.

In an implementation of the second aspect, the flexible display panel includes a first organic layer, a first touch layer, a second organic layer, a second touch layer, and a second black matrix. The first organic layer covers the encapsulation layer, the plurality of color filter layers, and the first black matrix. The first touch layer is formed on the first organic layer. The second organic layer covers the first organic layer and the first touch layer. The second touch layer and the second black matrix are both formed on the second organic layer, and the second black matrix covers the second touch layer. A projection of the second black matrix in the thickness direction of the flexible display panel overlaps the first black matrix. Two layers of black matrices are designed, so that reflectivity of the display panel can be enhanced, and display performance of the display panel can be improved.

In an implementation of the second aspect, the flexible display panel includes a first touch layer, an organic layer, and a second black matrix. The first touch layer is formed on the first black matrix. The organic layer covers the encapsulation layer, the plurality of color filter layers, the first touch layer, and the first black matrix. The second black matrix is formed on the organic layer. A projection of the second black matrix in the thickness direction of the flexible display panel overlaps the first black matrix. The second black matrix is used as a second touch layer. The first black matrix and the second black matrix are designed, so that reflectivity of the display panel can be enhanced, and display performance of the display panel can be improved. In addition, the second black matrix has functions of both a black matrix and a touch layer, so that stacked layers of the panel can be reduced, a fabrication process can be simplified, and costs can be reduced.

According to a third aspect, this application provides a flexible display panel. The flexible display panel includes a plurality of OLED devices, an encapsulation layer, an organic layer, and a plurality of color filter layers. The encapsulation layer covers the plurality of OLED devices. The organic layer covers the encapsulation layer. The organic layer has a plurality of holes. A projection of one of the OLED devices in a thickness direction of the flexible display panel correspondingly falls into one of the holes. The plurality of color filter layers are all formed on the organic layer. Each color filter layer is correspondingly filled in one of the holes. Each color filter layer is configured to transmit light emitted by an OLED device corresponding to the color filter layer.

In this solution, the holes are drilled on the organic layer, and the color filter layer is filled in the hole. In this way, in comparison with a conventional flexible display panel, a spacing between the color filter layer and the OLED device can be reduced, so that a light exit angle of the OLED device is large. This helps increase a visible angle of the display panel, and therefore can resolve problems of optical viewing angle color shift and viewing angle brightness attenuation. Therefore, compared with an image viewed by a user at a position facing a center of a screen, an image viewed on a side of a display does not have an obvious color difference and obvious brightness attenuation.

In an implementation of the third aspect, the organic layer includes a first organic layer and a second organic layer. The first organic layer covers the encapsulation layer. The second organic layer covers the first organic layer. The hole is provided on the second organic layer. This solution can meet a product requirement.

In an implementation of the third aspect, the organic layer includes a first organic layer and a second organic layer. The first organic layer covers the encapsulation layer. The hole is provided on the first organic layer. The second organic layer covers the first organic layer and is located on an outer periphery of the hole. This solution can further reduce the distance between the color filter layer and the OLED device, and further resolve problems of optical viewing angle color shift and viewing angle brightness attenuation.

In an implementation of the third aspect, the flexible display panel includes a black matrix. The black matrix is formed on the second organic layer and is located on the outer periphery of the hole. Two adjacent color filter layers are separated by the black matrix. The black matrix can absorb ambient light, reduce reflectivity of the display panel, and improve display performance of the display panel.

In an implementation of the third aspect, the flexible display panel includes a first touch layer and a second touch layer. The first touch layer is formed on the first organic layer. The second organic layer further covers the first touch layer. The second touch layer is formed on the second organic layer. The black matrix covers the second touch layer. This solution can meet a product requirement.

In an implementation of the third aspect, adjacent parts of every two adjacent color filter layers are stacked together. In this solution, the adjacent parts of the adjacent color filter layers are stacked together, so that a stacked part may absorb a part of ambient light, and the stacked part acts as a black matrix. The stacked part is formed, so that a fabrication process of the black matrix can be omitted, thereby simplifying a panel technology and reducing costs.

In an implementation of the third aspect, the flexible display panel includes a first touch layer and a second touch layer. The first touch layer is formed on the first organic layer. The second organic layer further covers the first touch layer. The second touch layer is formed on the second organic layer. The stacked parts of every two adjacent color filter layers cover the second touch layer. In this solution, the adjacent parts of the adjacent color filter layers are stacked together, so that the stacked part may absorb a part of ambient light, and the stacked part acts as a black matrix. The stacked part is formed, so that a fabrication process of the black matrix can be omitted, thereby simplifying a panel technology and reducing costs.

In an implementation of the third aspect, the flexible display panel includes a pixel define layer and a first optical structure. Two adjacent OLED devices are separated by the pixel define layer. The first optical structure is formed on the pixel define layer. The encapsulation layer further covers the pixel define layer and the first optical structure. The first optical structure is configured to reflect, to the black matrix, external light incident through the color filter layer. In this solution, the first optical structure is designed, so that an external light ray that is incident to the first optical structure can be reflected to the black matrix. Therefore, the reflectivity of the display panel can be further reduced, and display performance of the display panel can be improved.

In an implementation of the third aspect, the flexible display panel includes a second optical structure. The second optical structure is formed on the encapsulation layer. The first organic layer further covers the second optical structure. The second optical structure is configured to reflect, to the outside of the flexible display panel, light emitted by the OLED device to a first touch layer and the black matrix. In this solution, the second optical structure is designed, so that a light ray emitted from the OLED device can be reflected to the color filter layer. In this way, a reflected light ray is transmitted from the color filter layer, and the light ray is prevented from being absorbed by the first touch layer and the black matrix due to side transmission to the first touch layer and the black matrix, thereby reducing brightness attenuation of the display panel.

In an implementation of the third aspect, a refractive index of the second optical structure is less than a refractive index of the first organic layer. In this solution, the refractive index of the second optical structure may be less than the refractive index of the first organic layer, so that when a side-transmitted light ray from the OLED device at a specific angle is transmitted on an interface between the first organic layer and the second optical structure, the light ray may be totally reflected, and a totally reflected light ray may be incident to the color filter layer. In this way, a light ray loss can be further reduced, thereby helping further reduce brightness attenuation of the display panel.

According to a fourth aspect, this application provides a flexible display panel. The flexible display panel includes a plurality of OLED devices, an encapsulation layer, and a plurality of color filter layers. The encapsulation layer covers the plurality of OLED devices. The plurality of color filter layers are located inside the encapsulation layer. A projection of each OLED device in a thickness direction of the flexible display panel overlaps one of the color filter layers. Each color filter layer is configured to transmit light emitted by an OLED device corresponding to the color filter layer.

In this solution, the color filter layer is fabricated inside the encapsulation layer. In this way, in comparison with a conventional flexible display panel, a spacing between the color filter layer and the OLED device can be greatly reduced, so that a light exit angle of the OLED device is large. This helps increase a visible angle of the display panel, and therefore can resolve problems of optical viewing angle color shift and viewing angle brightness attenuation. Therefore, compared with an image viewed by a user at a position facing a center of a screen, an image viewed on a side of a display does not have an obvious color difference and obvious brightness attenuation.

In an implementation of the fourth aspect, the encapsulation layer includes a first inorganic layer, an encapsulation organic layer, and a second inorganic layer. The first inorganic layer covers the plurality of OLED devices. The plurality of color filter layers are formed on the first inorganic layer. The encapsulation organic layer covers the first inorganic layer and the plurality of color filter layers. The second inorganic layer covers the encapsulation organic layer. In this solution, in a panel architecture in which a thin film is used for encapsulation, effect of reducing optical viewing angle color shift and viewing angle brightness attenuation can be achieved.

In an implementation of the fourth aspect, the flexible display panel includes a first black matrix. The first black matrix is located inside the encapsulation layer and adjacent to the color filter layer. Two adjacent color filter layers are separated by the first black matrix. The black matrix can absorb ambient light, reduce reflectivity of the display panel, and improve display performance of the display panel.

In an implementation of the fourth aspect, adjacent parts of every two adjacent color filter layers are stacked together. In this solution, the adjacent parts of the adjacent color filter layers are stacked together, so that a stacked part may absorb a part of ambient light, and the stacked part acts as a black matrix. The stacked part is formed, so that a fabrication process of the black matrix can be omitted, thereby simplifying a panel technology and reducing costs.

In an implementation of the fourth aspect, the flexible display panel includes a first organic layer, a first touch layer, a second organic layer, a second touch layer, and a second black matrix. The first organic layer covers the encapsulation layer. The first touch layer is formed on the first organic layer. The second organic layer covers the first organic layer and the first touch layer. The second touch layer and the second black matrix are both formed on the second organic layer. The second black matrix covers the second touch layer. Two layers of black matrices are designed, so that reflectivity of the display panel can be enhanced, and display performance of the display panel can be improved.

According to a fifth aspect, this application provides an electronic device. The electronic device includes a cover plate and the flexible display panel according to any one of the implementations. The cover plate is attached to the flexible display panel. In this solution, a spacing between a color filter layer and an OLED device is reduced, so that problems of optical viewing angle color shift and viewing angle brightness attenuation can be resolved, thereby achieving good display performance of the electronic device and good user experience.

### BRIEF DESCRIPTION OF DRAWINGS

FIG. 1 is a diagram of a cross-sectional structure of a display panel according to Embodiment 1;
FIG. 1a is a diagram of a cross-sectional structure of a display panel according to another embodiment;
FIG. 2 is a diagram of a cross-sectional structure of an existing display panel;
FIG. 3 is a diagram of a cross-sectional structure of a display panel according to Embodiment 2;
FIG. 4 is a diagram of a cross-sectional structure of a display panel according to Embodiment 3;
FIG. 5 is a diagram of a cross-sectional structure of a display panel according to Embodiment 4;
FIG. 6 is a diagram of a cross-sectional structure of a display panel according to Embodiment 5;
FIG. 7 is a diagram of a cross-sectional structure of a display panel according to Embodiment 6;
FIG. 8 is a diagram of a cross-sectional structure of a display panel according to Embodiment 7;
FIG. 9 is a diagram of a cross-sectional structure of a display panel according to Embodiment 8;
FIG. 10 is a diagram of a cross-sectional structure of a display panel according to Embodiment 9;
FIG. 11 is a diagram of a cross-sectional structure of a display panel according to Embodiment 10;
FIG. 12 is a diagram of a cross-sectional structure of a display panel according to Embodiment 11;
FIG. 13 is a diagram of a cross-sectional structure of a display panel according to Embodiment 12;
FIG. 14 is a diagram of a cross-sectional structure of another display panel according to Embodiment 12;
FIG. 15 is a diagram of a cross-sectional structure of a display panel according to Embodiment 13;
FIG. 16 is a diagram of a cross-sectional structure of another display panel according to Embodiment 13;
FIG. 17 is a diagram of a cross-sectional structure of a display panel according to Embodiment 14; and
FIG. 18 is a diagram of a cross-sectional structure of another display panel according to Embodiment 14.

### DESCRIPTION OF EMBODIMENTS

For ease of understanding, the following explains and describes related technical terms and expressions in embodiments of this application.

The terms such as "first" and "second" are merely intended for a purpose of distinguishable description, and shall not be understood as an indication or implication of relative importance or an implicit indication of a quantity of indicated technical features. Therefore, a feature limited by "first", "second", or the like may explicitly or implicitly include one or more features.

The expression "A is formed on B" means that A is fabricated on a surface of B by using a fabrication process, and all or a part of A is combined with the surface of B.

The following describes embodiments of this application with reference to the accompanying drawings in embodiments of this application.

The following embodiments of this application provide an electronic device, including but not limited to a mobile phone (for example, a bar-type mobile phone, a foldable mobile phone, or a rollable mobile phone), a tablet computer, a notebook computer, a vehicle-mounted device (for example, an in-vehicle infotainment), a wearable device (for example, a smart watch, a virtual reality device, or an augmented reality device), a smart screen, and the like. The electronic device has a display.

The display may include a cover plate and a display panel. The cover plate is attached to the display panel, and the display panel is closed by the cover plate and a housing. The cover plate is used to protect the display panel. The cover plate is hard, and can provide tactile and force feedback to a user when the user touches the cover plate. The cover plate may be a rigid cover plate, and the rigid cover plate cannot be bent. Such a cover plate may be used on a rigid screen. Alternatively, the cover plate may be a flexible cover plate, and the flexible cover plate is easy to bend. Such a cover plate may be used in a foldable device or a rollable device.

A bending resistance capability of the display panel is usually a key to evaluate a bending capability of the foldable device or the rollable device. A conventional display panel is prone to bending and deformation at a bending crease because an internal inorganic layer has a poor deformation resistance capability, resulting in poor bending reliability of the display panel. Compared with the inorganic layer, an organic layer usually has a better deformation resistance capability. Therefore, in a current design solution, the inorganic layer that has a large impact on a bending capability is replaced with the organic layer, to improve bending reliability of the display panel. The following describes an internal structure of the display panel in embodiments of this application.

### Embodiment 1:

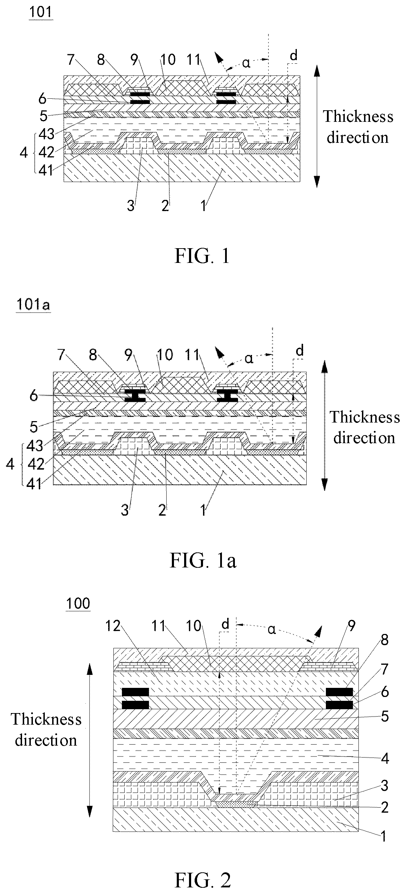

FIG. 1 shows an internal structure of a display panel 101 in a cross-sectional view. As shown in FIG. 1, the display panel 101 may include a TFT (Thin Film Transistor, thin film transistor) backplane 1, an OLED (Organic Light-Emitting Diode, organic light-emitting diode) device 2, a pixel define layer (Pixel Define Layer, PDL) 3, an encapsulation layer 4, a first organic layer 5, a first touch layer 6, a second organic layer 7, a second touch layer 8, a black matrix 9, a color filter layer 10, and a planarization layer 11.

The TFT backplane 1 may include a TFT array layer and a substrate. The TFT array layer is formed on the substrate, for example, may be formed on a buffer layer in the substrate. The TFT array layer may include a TFT array including a plurality of criss-crossed TFTs, and the TFT array layer may include an anode (an anode of an OLED device).

The OLED device 2 may include an OLED light-emitting material, for example, an organic small molecular light-emitting material, a complex light-emitting material, or a polymer. There may be a plurality of OLED devices 2, and the plurality of OLED devices 2 may include a plurality of red-light parts R (which can emit red light), a plurality of green-light parts G (which can emit green light), and a plurality of blue-light parts B (which can emit blue light). These light-emitting parts of different colors are arranged in an array. Each red-light part R may be referred to as one red subpixel R, each green-light part G may be referred to as one green subpixel G, and each blue-light part B may be referred to as one blue subpixel B.

As shown in FIG. 1, the OLED device 2 and the pixel define layer 3 are formed on the TFT backplane 1, adjacent OLED devices 2 are separated by the pixel define layer 3, and the pixel define layer 3 is located around the OLED device 2. The encapsulation layer 4 covers the OLED device 2 and the pixel define layer 3.

As shown in FIG. 1, the encapsulation layer 4 may include a first inorganic layer 41, an encapsulation organic layer 42, and a second inorganic layer 43. The first inorganic layer 41, the encapsulation organic layer 42, and the second inorganic layer 43 may be sequentially stacked. The first inorganic layer 41 covers the OLED device 2 and the pixel define layer 3.

The encapsulation layer 4 is configured to implement encapsulation of the display panel. For example, in this embodiment, the encapsulation layer 4 may be fabricated by using a thin film encapsulation (Thin Film Encapsulation, TFE) technology. In another embodiment, the encapsulation layer 4 may alternatively use another encapsulation manner.

As shown in FIG. 1, the first organic layer 5 may be formed on the second inorganic layer 43 of the encapsulation layer 4. The first organic layer 5 may be made of an insulative organic material, for example, resin of an acrylic system.

As shown in FIG. 1, the first touch layer 6 may be formed on the first organic layer 5. The first touch layer 6 may be made of metal.

As shown in FIG. 1, the second organic layer 7 covers the first organic layer 5 and the first touch layer 6. The second organic layer 7 may be made of an insulative organic material, for example, resin of an acrylic system.

As shown in FIG. 1, the second touch layer 8 is formed on the second organic layer 7. In a thickness direction, the first touch layer 6 may be stacked with the second touch layer 8. The first touch layer 6 and the second touch layer 8 may form a touch electrode of the display panel, so that the display panel has a touch function.

In this embodiment, the first organic layer 5, the first touch layer 6, the second organic layer 7, and the second touch layer 8 may belong to layers in a touch panel (touch panel, TP) of the display panel. The first touch layer 6 and the second touch layer 8 each may be one electrode (for example, one is an Rx electrode, and the other is a Tx electrode), and the two electrodes are respectively located on two layers. This design may be referred to as a non-bridging solution.

In this embodiment, an on-cell solution may be used, and the touch panel is integrally formed on the encapsulation layer 4. Because the first organic layer 5 and the second organic layer 7 in the touch panel have good deformation resistance performance, a bending resistance capability of the display panel can be improved, so that the display panel has good bending reliability.

For example, in this embodiment, the first touch layer 6 and the second touch layer 8 implement touch control on the display panel by using a mutual-capacitance touch technology. In another embodiment, a self-capacitance touch technology may alternatively be used to implement touch control on the display panel. A touch control manner of the display panel is not specifically limited in this embodiment, and a person skilled in the art can design the touch manner according to an actual requirement.

As shown in FIG. 1, the black matrix 9 (which may be referred to as a first black matrix) is formed on the second organic layer 7, and covers the second touch layer 8. The black matrix 9 may absorb a light ray from an external environment, to prevent the second touch layer 8 from reflecting the external light ray, thereby helping reduce reflectivity of the display panel and improve display performance of the display panel.

As shown in FIG. 1, the color filter layer 10 is formed on the second organic layer 7. The color filter layer 10 may be stacked with the OLED device 2 in the thickness direction. There are a plurality of color filter layers 10. Adjacent color filter layers 10 may be separated by the black matrix 9. The color filter layer 10 may include a color filter layer R that can transmit red light and filter light of another band, a color filter layer G that can transmit green light and filter light of another band, and a color filter layer B that can transmit blue light and filter light of another band. The color filter layer R may be correspondingly stacked with the red subpixel R, and red light emitted by the red subpixel R may pass through the color filter layer R. The color filter layer G may be correspondingly stacked with the red subpixel G, and red light emitted by the red subpixel G may pass through the color filter layer G. The color filter layer B may be correspondingly stacked with the red subpixel B, and red light emitted by the red subpixel B may pass through the color filter layer B.

For example, in this embodiment, a projection of an edge of the color filter layer 10 may be connected to or partially overlap a projection of the black matrix 9 in the thickness direction. In another embodiment, the color filter layer 10 may alternatively not be connected to the black matrix 9. A position relationship between the color filter layer 10 and the black matrix 9 is not specifically limited in this embodiment, and a person skilled in the art can design the position relationship according to an actual requirement.

As shown in FIG. 1, the planarization layer 11 covers the second organic layer 7, the black matrix 9, and the color filter layer 10. The planarization layer 11 may be transparent photoresist. The planarization layer 11 has insulation performance, and can provide a planarization surface, so that another structural layer is fabricated on or attached to the planarization layer 11 by using a subsequent fabrication process. For example, an optical adhesive layer is formed on the planarization layer 11, and the planarization layer is attached to a cover plate by using the optical adhesive layer.

In this embodiment, forming the color filter layer 10, the black matrix 9, and the planarization layer 11 on the encapsulation layer 4 is a design of fabricating a display panel without a polarizer based on a color filter on encapsulation (Color filter On Encapsulation, COE) technology. Because the color filter layer 10 has a high transmittance to an R/G/B spectrum and a high absorption rate to a spectrum of another band, and the black matrix 9 has absorption effect on the spectrum, the display panel in this embodiment has low reflectivity to an ambient light, good contrast, high brightness, and low power consumption.

Compared with a conventional display panel 100 shown in FIG. 2, the touch panel of the display panel 101 shown in FIG. 1 includes the first organic layer 5 and the second organic layer 7, but a touch panel of the conventional display panel 100 includes a first organic layer 5, a second organic layer 7, and a third organic layer 12. In other words, compared with the conventional display panel 100, the display panel 101 in this embodiment lacks the third organic layer 12.

As shown in FIG. 1 and FIG. 2, in a thickness direction, a distance from an OLED device 2 to a color filter layer 10 corresponding to the OLED device 2 is d, and a light exit angle of the OLED device 2 is α (a vertex of the light exit angle α may be a center of the OLED device 2, one edge of the light exit angle α may be parallel to the thickness direction, and the other edge of the light exit angle α may pass through an edge of the color filter layer 10 corresponding to the OLED device 2). It can be learned from analysis that, because compared with the conventional display panel 100, the display panel 101 lacks the third organic layer 12, a distance d shown in FIG. 1 is less than a distance d shown in FIG. 2. Therefore, a light exit angle α shown in FIG. 1 is greater than a light exit angle α shown in FIG. 2.

As shown in FIG. 1, in the solution in Embodiment 1, the third organic layer 12 is removed, so that the distance d between the OLED device 2 and a color filter layer 10 is small, and the light exit angle α of the OLED device 2 can be large. This helps increase a visible angle of the display panel 101, and therefore can resolve problems of optical viewing angle color shift and viewing angle brightness attenuation. Therefore, compared with an image viewed by a user at a position facing a center of a screen, an image viewed on a side of a display does not have an obvious color difference and obvious brightness attenuation. In addition, removing the third organic layer 12 may further simplify the structure and a fabrication technology of the display panel 101, thereby reducing technology costs of the display panel 101. In addition, in the solution in Embodiment 1, a pixel define layer gap (PDL gap) may be small, and an opening rate may be large, so that a pixel may have a long life.

In another embodiment, different from the display panel 101 shown in FIG. 1, in a display panel 101a shown in FIG. 1a, a first touch layer 6 may pass through a hole of a second organic layer 7, and a part of the first touch layer 6 is combined with a first organic layer 5 (it may be considered that the first touch layer 6 is formed on the first organic layer 5). A touch panel in the display panel 101a may use a bridging solution. To be specific, a second touch layer 8 may include an Rx electrode and a Tx electrode. One of the electrodes may be disconnected at a position at which the two electrodes intersect. Two disconnected parts may be connected through the first touch layer 6 (which may be referred to as a bridging structure) for conduction. The first touch layer 6 is not in contact with the other electrode. In this way, the Rx electrode and the Tx electrode are not in contact with each other and are not short-circuited.

It should be noted that the foregoing non-bridging solution or bridging solution may be used in all embodiments of this application. The following embodiments are further described by using the non-bridging solution as an example. It may be understood that this is merely an example, and does not constitute a limitation on embodiments of this application.

### Embodiment 2:

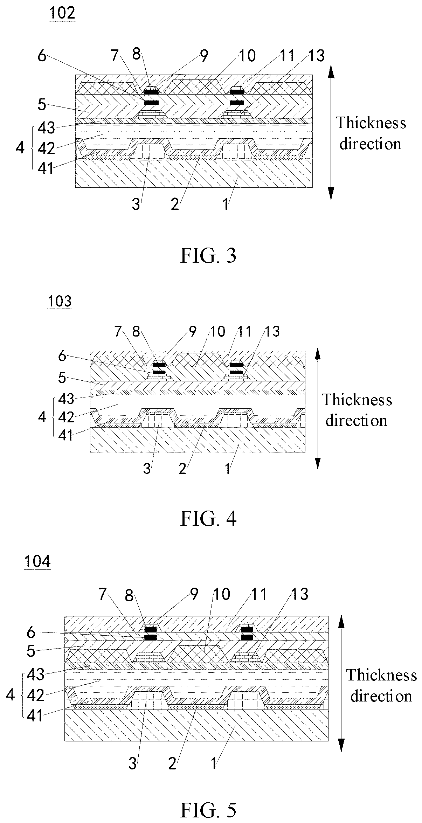

FIG. 3 shows an internal structure of a display panel 102 in a cross-sectional view. In comparison between the display panel in FIG. 3 and the display panel 101 in Embodiment 1 in FIG. 1, a difference is as follows.

In the display panel 102 in Embodiment 2, a black matrix 13 may be further formed on a second inorganic layer 43. A first organic layer 5 covers the second inorganic layer 43 and the black matrix 13. In a thickness direction, the black matrix 13 may overlap a first touch layer 6 and a black matrix 9. For differentiation, the black matrix 13 may be referred to as a second black matrix, and the black matrix 9 may be referred to as a first black matrix.

In this embodiment, the black matrix 13 may absorb an ambient light ray, to avoid reflection of the ambient light ray by a structural layer (for example, a pixel define layer 3) in the display panel 102. Two layers of black matrices, namely, the black matrix 13 and the black matrix 9, are disposed, so that reflectivity of the display panel 101 can be enhanced, and display performance of the display panel 101 can be improved. In addition, because the first organic layer 5 is between the black matrix 13 and the first touch layer 6, a fabrication process (which may include etching) of the first touch layer 6 does not cause damage to the black matrix 13. This can ensure optical shielding effect of the black matrix 13.

It may be understood that a distance between an OLED device 2 and a color filter layer 10 in Embodiment 2 is small, so that problems of optical viewing angle color shift and viewing angle brightness attenuation can also be resolved in Embodiment 2.

### Embodiment 3:

FIG. 4 shows an internal structure of a display panel 103 in a cross-sectional view. In comparison between the display panel in FIG. 4 and the display panel 101 in Embodiment 1 in FIG. 1, a difference is as follows.

In the display panel 103 in Embodiment 3, a black matrix 13 may be further formed on a first organic layer 5. A first touch layer 6 is formed on the black matrix 13. A second organic layer 7 covers the first touch layer 6 and the black matrix 13. In a thickness direction, the black matrix 13 may overlap the first touch layer 6 and a black matrix 9. For differentiation, the black matrix 13 may be referred to as a second black matrix, and the black matrix 9 may be referred to as a first black matrix.

In this embodiment, the black matrix 13 may absorb an ambient light ray, to avoid reflection of the ambient light ray by a structural layer (for example, a pixel define layer 3) in the display panel 103. Two layers of black matrices, namely, the black matrix 13 and the black matrix 9, are disposed, so that reflectivity of the display panel 103 can be enhanced, and display performance of the display panel 103 can be improved. In addition, because the first organic layer 5 is between the black matrix 13 and a second inorganic layer 43, fabrication processes (which may include etching and dry etching) of the black matrix 13 and the first touch layer 6 do not cause damage to the second inorganic layer 43. This can ensure encapsulation reliability of an encapsulation layer 4.

It may be understood that a distance between an OLED device 2 and a color filter layer 10 in Embodiment 3 is small, so that problems of optical viewing angle color shift and viewing angle brightness attenuation can also be resolved in Embodiment 3.

### Embodiment 4:

FIG. 5 shows an internal structure of a display panel 104 in a cross-sectional view. In comparison between the display panel in FIG. 5 and the display panel 102 in Embodiment 2 in FIG. 3, a difference is as follows.

In the display panel 104 in Embodiment 4, a color filter layer 10 is formed on a second inorganic layer 43. In a thickness direction, the color filter layer 10 may be stacked with and correspond to an OLED device 2. Adjacent color filter layers 10 may be separated by a black matrix 13 (which may be referred to as a first black matrix, and correspondingly, a black matrix 9 may be referred to as a second black matrix). A first organic layer 5 covers the black matrix 13 and the color filter layer 10.

For example, in this embodiment, a projection of the color filter layer 10 may be connected to or partially overlap a projection of the black matrix 13 in the thickness direction, or may not be connected to a projection of the black matrix 13. A position relationship between the color filter layer 10 and the black matrix 13 is not specifically limited in this embodiment, and a person skilled in the art can design the position relationship according to an actual requirement.

In Embodiment 4, the color filter layer 10 is moved down to the second inorganic layer 43, so that a distance from the color filter layer 10 to the OLED device 2 can be further shortened. Therefore, viewing angle brightness attenuation can be further reduced, optical viewing angle color shift can be reduced, and display performance of the display panel 104 can be improved.

### Embodiment 5:

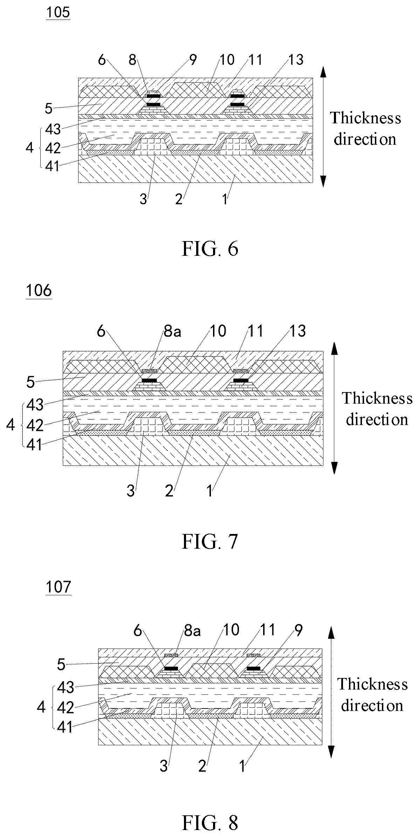

FIG. 6 shows an internal structure of a display panel 105 in a cross-sectional view. In comparison between the display panel in FIG. 6 and the display panel 102 in Embodiment 2 in FIG. 3, a difference is as follows.

The display panel 105 in Embodiment 5 lacks the second organic layer 7. Specifically, as shown in FIG. 6, in the display panel 105, a first touch layer 6 is formed on a black matrix 13 (which may be referred to as a second black matrix), and a first organic layer 5 covers the black matrix 13 and the first touch layer 6. A second touch layer 8, a black matrix 9 (which may be referred to as a first black matrix), and a color filter layer 10 are formed on the first organic layer 5. The black matrix 9 covers the second touch layer 8, and the black matrix 9 separates adjacent color filter layers 10. In a thickness direction, the first touch layer 6 may be stacked with the second touch layer 8.

It can be learned from analysis that, because compared with the display panel 102, the display panel 105 lacks the second organic layer 7, a distance between the color filter layer 10 and an OLED device 2 is further reduced in the thickness direction. Therefore, problems of optical viewing angle color shift and viewing angle brightness attenuation can be resolved. In addition, removing the second organic layer 7 may further simplify the structure and a fabrication technology of the display panel 105, thereby reducing technology costs of the display panel 105. In addition, the black matrix 13 can prevent a second inorganic layer 43 from damage caused by a fabrication process (which may include dry etching) of the first touch layer 6, thereby helping ensure encapsulation reliability of an encapsulation layer 4.

### Embodiment 6:

FIG. 7 shows an internal structure of a display panel 106 in a cross-sectional view. In comparison between the display panel in FIG. 7 and the display panel 105 in Embodiment 5 in FIG. 6, a difference is as follows.

In the display panel 106 in Embodiment 6, a black matrix 9 may not need to be formed on a first organic layer 5, and the second touch layer 8 shown in FIG. 6 may be oxidized into a second touch layer 8a shown in FIG. 7.

For example, the second touch layer 8a may be obtained by oxidizing the touch layer by using an oxidation technology (for example, O₂ plasma) after the touch layer is etched (a metal grid is formed), so that a surface of the touch layer is oxidized into metal oxides such as Ti₂O₃ and Al₂O₃, thereby reducing reflection of the surface of the touch layer on ambient light. In other words, the second touch layer 8a may have a reflectivity reduction function of the black matrix 9.

For example, in this embodiment, a projection of a color filter layer 10 may be connected to or partially overlap a projection of the second touch layer 8a in a thickness direction, or may not be connected to a projection of the second touch layer 8a. A position relationship between the color filter layer 10 and the second touch layer 8a is not specifically limited in this embodiment, and a person skilled in the art can design the position relationship according to an actual requirement.

In Embodiment 6, the second touch layer 8a may form a touch electrode of the display panel with a first touch layer 6, so that the display panel has a touch function, and the second touch layer 8a may also replace a second black matrix 13 to absorb reflected light from an environment. Therefore, a design of the second touch layer 8a helps reduce reflectivity of the display panel 106 to ambient light, and improve display performance of the display panel 106, and can also simplify the structure of the display panel, reduce a fabrication technology, and reduce fabrication costs.

It may be understood that a distance between an OLED device 2 and the color filter layer 10 in Embodiment 6 is small, so that problems of optical viewing angle color shift and viewing angle brightness attenuation can also be resolved in Embodiment 6.

### Embodiment 7:

FIG. 8 shows an internal structure of a display panel 107 in a cross-sectional view. In comparison between the display panel in FIG. 8 and the display panel 106 in Embodiment 6 in FIG. 7, a difference is as follows.

In the display panel 107 in Embodiment 7, a color filter layer 10 is formed on a second inorganic layer 43. In a thickness direction, the color filter layer 10 may be stacked with and correspond to an OLED device 2. Adjacent color filter layers 10 may be separated by a black matrix 9 (which may be referred to as a first black matrix). The first organic layer 5 covers the black matrix 9, a first touch layer 6, and the color filter layer 10.

For example, in this embodiment, a projection of the color filter layer 10 may be connected to or partially overlap a projection of the black matrix 9 in the thickness direction, or may not be connected to a projection of the black matrix 9. A position relationship between the color filter layer 10 and the black matrix 9 is not specifically limited in this embodiment, and a person skilled in the art can design the position relationship according to an actual requirement.

In the display panel 107 in Embodiment 7, the color filter layer 10 is formed on the second inorganic layer 43. Therefore, a distance between the color filter layer 10 and the OLED device 2 is further reduced in the thickness direction. Therefore, viewing angle brightness attenuation can be further reduced, optical viewing angle color shift can be reduced, and display performance of the display panel 107 can be improved. In addition, a design of the second touch layer 8a helps reduce reflectivity of the display panel 107 to ambient light, and improve display performance of the display panel 107, and can also simplify the structure of the display panel, reduce a fabrication technology, and reduce fabrication costs.

### Embodiment 8:

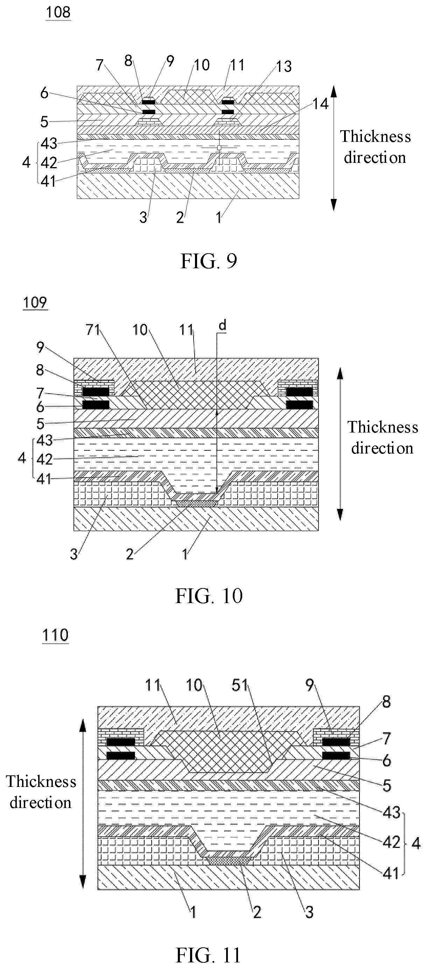

FIG. 9 shows an internal structure of a display panel 108 in a cross-sectional view. In comparison between the display panel in FIG. 9 and the display panel 102 in Embodiment 2 in FIG. 3, a difference is as follows.

In the display panel 108 in Embodiment 8, a third organic layer 14 may be further formed on a second inorganic layer 43. A black matrix 13 is formed on the third organic layer 14. A first organic layer 5 covers the third organic layer 14 and the black matrix 13.

In Embodiment 8, the third organic layer 14 may protect the second inorganic layer 43 from damage caused by a fabrication process (which may include etching) of the black matrix 13, thereby improving encapsulation reliability of an encapsulation layer 4. In addition, because the first organic layer 5 is between the black matrix 13 and a first touch layer 6, a fabrication process (which may include etching) of the first touch layer 6 does not cause damage to the black matrix 13. This can ensure optical shielding effect of the black matrix 13.

In this embodiment, a thickness of the third organic layer 14 may be controlled, so that a distance between an OLED device 2 and a color filter layer 10 in Embodiment 8 is a small value. In this way, in Embodiment 8, problems of optical viewing angle color shift and viewing angle brightness attenuation can be resolved to some extent.

### Embodiment 9:

FIG. 10 shows an internal structure of a display panel 109 in a cross-sectional view. In comparison between the display panel in FIG. 10 and the display panel 101 in Embodiment 1 in FIG. 1, a difference is as follows.

As shown in FIG. 10, a second organic layer 7 covers a first organic layer 5 and a first touch layer 6. A first hole 71 may be formed on the second organic layer 7. For example, the first hole 71 may be a through hole, that is, a material of the second organic layer 7 is removed from an area of the first hole 71, to expose the first organic layer 5. Alternatively, the first hole 71 may be a blind hole.

As shown in FIG. 10, a projection of an OLED device 2 may fall within a boundary of the first hole 71 of the second organic layer 7 in a thickness direction of the display panel 109. This may include that there is a spacing between the boundary of the first hole 71 and each of all projection boundaries of the OLED device 2, or at least a part of projection boundaries of the OLED device 2 overlap the boundary of the first hole 71. For example, a shape of the first hole 71 may be similar to a shape of the OLED device 2.

As shown in FIG. 10, a second touch layer 8 is formed on the second organic layer 7, and is located in an area that is on the second organic layer 7 and in which no first hole 71 is provided. In the thickness direction, the first touch layer 6 may be stacked with the second touch layer 8. The first touch layer 6 and the second touch layer 8 may form a touch electrode of the display panel, so that the display panel has a touch function.

As shown in FIG. 10, a black matrix 9 is formed on the second organic layer 7, and is located in the area that is on the second organic layer 7 and in which no first hole 71 is provided. The black matrix 9 covers the second touch layer 8. A color filter layer 10 is formed on the second organic layer 7, and is filled in the first hole 71. The color filter layer 10 may be stacked with the OLED device 2 in the thickness direction.

For example, in this embodiment, a projection of an edge of the color filter layer 10 may be on a projection of an outer periphery of the boundary of the first hole 71 in the thickness direction, and is not connected to a projection of the black matrix 9. In another embodiment, a projection of the color filter layer 10 may alternatively be on a projection of an outer periphery of the boundary of the first hole 71, and partially overlap a projection of the black matrix 9. A position relationship between the color filter layer 10 and the black matrix 9 is not specifically limited in this embodiment, and a person skilled in the art can design the position relationship according to an actual requirement.

In the solution in Embodiment 9, the first hole 71 is formed on the second organic layer 7, and the color filter layer 10 is filled in the first hole 71, so that the color filter layer 10 sinks in the thickness direction, and a distance d between the OLED device 2 and the color filter layer 10 is small. The distance d between the OLED device 2 and the color filter layer 10 is small, so that problems of optical viewing angle color shift and viewing angle brightness attenuation of the display panel 109 can be resolved.

### Embodiment 10:

FIG. 11 shows an internal structure of another display panel 110 in a cross-sectional view. In comparison between the display panel in FIG. 11 and the display panel 109 in Embodiment 9 in FIG. 10, a difference is as follows.

In the display panel 110 in Embodiment 10, a second hole 51 is formed on a first organic layer 5. The second hole 51 may be a blind hole, and may be referred to as a groove 51. A thickness of a bottom wall of the groove 51 may be small, for example, may be 0.1 µm to 2.0 µm. A second organic layer 7 may cover an area that is on the first organic layer 5 and in which no second hole 51 is provided, and the second organic layer 7 may not be filled in the second hole 51. A color filter layer 10 may be filled in the second hole 51, and may cover the first organic layer 5 and the second organic layer 7.

As shown in FIG. 11, a projection of an OLED device 2 may fall within a boundary of the second hole 51 of the first organic layer 5 in a thickness direction of the display panel 110. This may include that there is a spacing between the boundary of the second hole 51 and each of all projection boundaries of the OLED device 2, or at least a part of projection boundaries of the OLED device 2 overlap the boundary of the second hole 51. For example, a shape of the second hole 51 may be similar to a shape of the OLED device 2.

In the solution in Embodiment 10, the color filter layer 10 is filled in the second hole 51 on the first organic layer 5, so that the color filter layer 10 further sinks in the thickness direction, and a distance between the OLED device 2 and the color filter layer 10 is further reduced. In this way, the display panel 110 does not have an obvious color difference and obvious brightness attenuation. This helps resolve problems of optical viewing angle color shift and viewing angle brightness attenuation of the display panel 110.

### Embodiment 11:

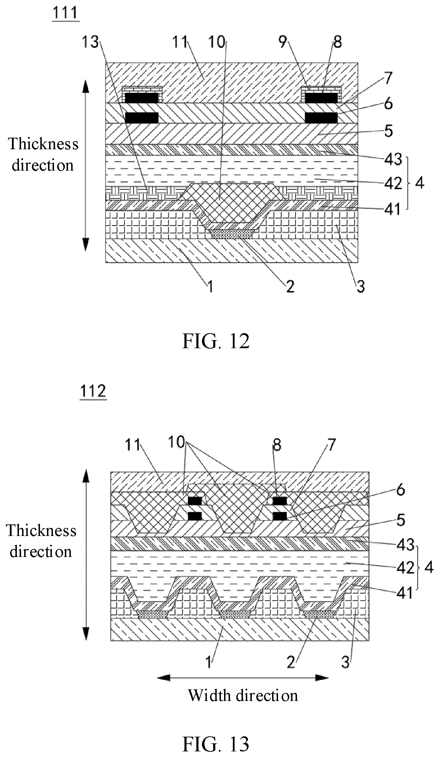

FIG. 12 shows an internal structure of another display panel 111 in a cross-sectional view. In comparison between the display panel in FIG. 12 and the display panel 109 in Embodiment 9 in FIG. 10, a difference is as follows.

In the display panel 111 in Embodiment 11, a color filter layer 10 and a black matrix 13 are located between a first inorganic layer 41 and an encapsulation organic layer 42 of an encapsulation layer 4, adjacent color filter layers 10 may be separated by the black matrix 13, and the black matrix 13 is located around the color filter layer 10. A projection of the color filter layer 10 may be stacked with a projection of an OLED device 2 in a thickness direction. In addition, a first hole 71 is no longer provided on a second organic layer 7 of the display panel 111.

In the solution in Embodiment 11, the color filter layer 10 is formed on the first inorganic layer 41 of the encapsulation layer 4. This effectively shortens a distance between the OLED device 2 and the color filter layer 10, and helps resolve problems of optical viewing angle color shift and viewing angle brightness attenuation of the display panel 111. In addition, the black matrix 13 may absorb an ambient light ray, to avoid reflection of the ambient light ray by a structural layer (for example, a pixel define layer 3) in the display panel 111. Two layers of black matrices, namely, the black matrix 13 and a black matrix 9, are disposed, so that reflectivity of the display panel 111 can be enhanced, and display performance of the display panel 111 can be improved.

### Embodiment 12:

FIG. 13 shows an internal structure of another display panel 112 in a cross-sectional view. In comparison between the display panel in FIG. 13 and the display panel 110 in Embodiment 10 in FIG. 11, a difference is as follows.

In the display panel 112 in Embodiment 12, adjacent color filter layers 10 partially overlap each other, and cover a second touch layer 8. An overlapping part of the color filter layers 10 may be used as a black matrix. Specifically, the color filter layer 10 is filled on a second hole 51 of a first organic layer 5, and the adjacent color filter layers 10 partially overlap each other on a second organic layer 7. In a thickness direction, a projection of the second touch layer 8 falls within an overlapping area of the adjacent color filter layers 10. In a width direction, an overlapping width of the adjacent color filter layers 10 may be determined based on a width of the second touch layer 8 and a width of a pixel define layer gap. For example, the overlapping width may be 3 µm to 10 µm. The overlapping width of the adjacent color filter layers 10 is not specifically limited in this embodiment, and a person skilled in the art can design the overlapping width according to an actual requirement.

Different color filter layers 10 may absorb light of different bands, and the color filter layer 10 may absorb light of more bands after overlapping. Therefore, the overlapping part of the color filter layers 10 that cover the second touch layer 8 may absorb more external ambient light rays, so that the second touch layer 8 is prevented from reflecting an external light ray, thereby reducing reflectivity of the display panel 112 and improving display performance. It can be learned that a function of the overlapping part of the color filter layers 10 is equivalent to a function of the black matrix 9 in FIG. 11. Therefore, in this embodiment, the black matrix 9 in FIG. 11 may not be formed.

The structure of the display panel 112 shown in FIG. 13 can reduce a distance between an OLED device 2 and the color filter layer 10, and can resolve problems of optical viewing angle color shift and viewing angle brightness attenuation of the display panel 112. In addition, removing the black matrix 9 can simplify the structure and a fabrication technology of the display panel, thereby reducing fabrication costs.

Based on the foregoing description, it is easy to understand that, in another embodiment, a design may be changed based on the solution in FIG. 10, so that adjacent color filter layers 10 partially overlap each other, and an overlapping part of the color filter layers 10 may be used as a black matrix. This can simplify the structure and a fabrication technology of the display panel 112, and reduce fabrication costs.

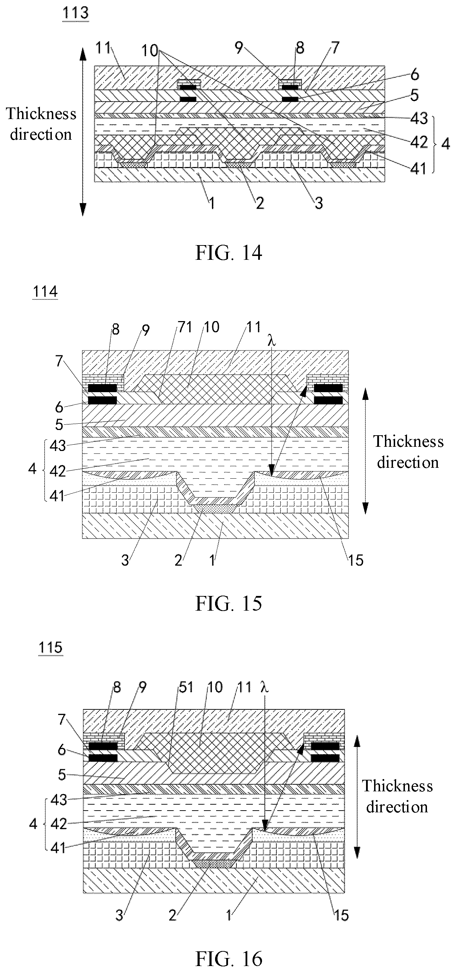

Alternatively, in another embodiment, a design may be changed based on the solution in FIG. 12, so that adjacent color filter layers 10 partially overlap each other. Specifically, a difference from the display panel 111 shown in FIG. 12 is that, in a display panel 113 shown in FIG. 14, adjacent color filter layers 10 may partially overlap each other. In a thickness direction, an overlapping part may fall within a range of a pixel define layer 3. A black matrix may not need to be formed on a first inorganic layer 41. In this embodiment, optical viewing angle color shift and viewing angle brightness attenuation are reduced, reflectivity is reduced, and display performance is improved. In addition, a structure of the display panel is further simplified, so that a fabrication technology is simpler and fabrication costs are lower.

### Embodiment 13:

FIG. 15 shows an internal structure of another display panel 114 in a cross-sectional view. In comparison between the display panel in FIG. 15 and the display panel 109 in Embodiment 9 in FIG. 10, a difference is as follows.

A first optical structure 15 is added to the display panel 114 shown in FIG. 15. Specifically, the first optical structure 15 is formed on a pixel define layer 3. A width of the first optical structure 15 may be basically the same as a width of a side that is of the pixel define layer 3 and that is close to a first inorganic layer 41. The first inorganic layer 41 of an encapsulation layer 4 covers an OLED device 2, the pixel define layer 3, and the first optical structure 15.

The first optical structure 15 may be made of an organic material, for example, a PDL or a PLN. The first optical structure 15 may deflect (for example, reflect or refract) a light ray, and the first optical structure 15 may be, for example, a concave lens or a concave lens. The first optical structure 15 is configured to reflect, to a black matrix 9, an external light ray λ that is incident to the first optical structure 15 through an edge of a color filter layer 10, so that a reflected light ray is absorbed by the black matrix 9. A material, a shape, and a position of the first optical structure 15 are not specifically limited in this embodiment, provided that the first optical structure 15 can reflect the external light ray that is incident through the edge of the color filter layer 10. A person skilled in the art can design the first optical structure 15 according to an actual requirement.

The first optical structure 15 in the display panel 114 shown in FIG. 15 may reflect, to the black matrix 9, the external light ray that is incident to the first optical structure 15. Therefore, reflectivity of the display panel 114 can be further reduced, and display performance of the display panel 114 can be improved.

It may be understood that, a distance between the OLED device 2 and the color filter layer 10 in the display panel 114 shown in FIG. 15 is small, so that problems of optical viewing angle color shift and viewing angle brightness attenuation can also be resolved.

It may be understood that, in another embodiment, a design change may be made based on the solution in FIG. 11, and a first optical structure 15 is added. Specifically, a difference from the display panel 110 shown in FIG. 11 is that, in a display panel 115 shown in FIG. 16, a first optical structure 15 is formed on a pixel define layer 3. A width of the first optical structure 15 may be basically the same as a width of a side that is of the pixel define layer 3 and that is close to a first inorganic layer 41. The first inorganic layer 41 of an encapsulation layer 4 covers an OLED device 2, the pixel define layer 3, and the first optical structure 15. The first optical structure 15 may reflect incident external ambient light to a black matrix 9. In this embodiment, optical viewing angle color shift and viewing angle brightness attenuation are reduced, reflectivity of the display panel is further reduced, optical display effect is optimized, and display performance is improved.

### Embodiment 14:

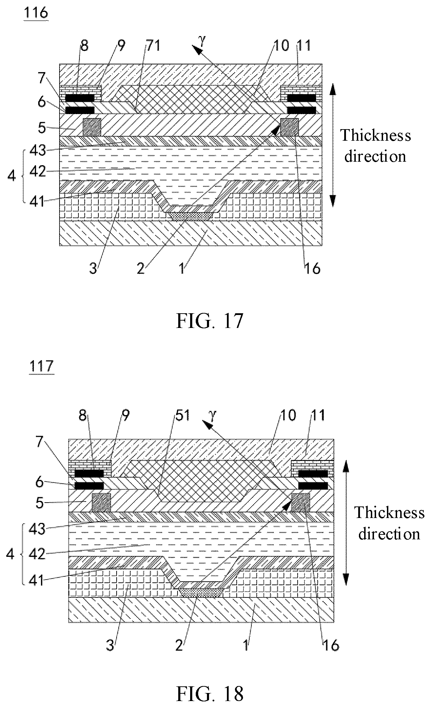

FIG. 17 shows an internal structure of another display panel 116 in a cross-sectional view. In comparison between the display panel in FIG. 17 and the display panel 109 in Embodiment 9 in FIG. 10, a difference is as follows.

A second optical structure 16 is added to the display panel 116 shown in FIG. 17. Specifically, the second optical structure 16 is formed on a second inorganic layer 43. In a thickness direction, the second optical structure 16 and an OLED device 2 may not correspondingly overlap each other, and may be staggered. In the thickness direction, the second optical structure 16 may fall within a boundary range of a pixel define layer 3. The second optical structure 16 is located on an optical path on which a light ray γ emitted by the OLED device 2 is side-transmitted to a first touch layer 6 and a black matrix 9. A first organic layer 5 covers the second inorganic layer 43 and the second optical structure 16.

For example, the second optical structure 16 may be made of an organic material. The second optical structure 16 may be formed by using an ink jet printing (Ink Jet Printing, IJP) technology. The second optical structure 16 may deflect (for example, reflect or refract) a light ray, and the second optical structure 16 may be, for example, a convex lens. The second optical structure 16 is configured to reflect, to a color filter layer 10, the light ray γ emitted by the OLED device 2, so that a reflected light ray is transmitted from the color filter layer 10, and the light ray γ is prevented from being absorbed by the first touch layer 6 and the black matrix 9 due to side transmission to the first touch layer 6, thereby reducing brightness attenuation of the display panel.

For example, a refractive index of the second optical structure 16 may be less than a refractive index of the first organic layer 5. When a side-transmitted light ray γ from the OLED device 2 at a specific angle is transmitted on an interface between the first organic layer 5 and the second optical structure 16, the light ray γ may be totally reflected, and a totally reflected light ray may be incident to the color filter layer 10. In this way, a light ray loss can be further reduced, thereby helping further reduce brightness attenuation of the display panel.

It may be understood that, a distance between the OLED device 2 and the color filter layer 10 in the display panel 116 shown in FIG. 17 is small, so that problems of optical viewing angle color shift and viewing angle brightness attenuation can also be resolved.

It may be understood that, in another embodiment, a design change may be made based on the solution in FIG. 10, and a second optical structure 16 is added. Specifically, a difference from the display panel 109 shown in FIG. 10 is that, in a display panel 117 shown in FIG. 18, a second optical structure 16 is formed on a second inorganic layer 43. In a thickness direction, the second optical structure 16 and an OLED device 2 may not correspondingly overlap each other, and may be staggered. The second optical structure 16 is located on an optical path on which a light ray γ emitted by the OLED device 2 is side-transmitted to a first touch layer 6 and a black matrix 9. A first organic layer 5 covers the second inorganic layer 43 and the second optical structure 16. The second optical structure 16 may reflect, to a color filter layer 10, a light ray γ emitted by the OLED device 2. In this embodiment, optical viewing angle color shift and viewing angle brightness attenuation can be reduced, thereby optimizing optical display effect and improving display performance.

Embodiments of this application are described above. The foregoing descriptions are examples, not exhaustive, and are not limited to the disclosed embodiments. Many modifications and changes are apparent to a person of ordinary skill in the art without departing from the scope and spirit of the described embodiments. Selection of terms used in this specification is intended to best explain the principles of embodiments, actual application, or improvements to technologies in the market, or to enable another person of ordinary skill in the art to understand embodiments disclosed in this specification.

## Claims

1. A flexible display panel, wherein
the flexible display panel comprises a plurality of OLED devices, an encapsulation layer, an organic layer, a plurality of color filter layers, and a first black matrix;
the encapsulation layer covers the plurality of OLED devices;
the organic layer covers the encapsulation layer, and a quantity of organic layers is less than 3; and
the plurality of color filter layers and the first black matrix are all formed on the organic layer, two adjacent color filter layers are separated by the first black matrix, a projection of each OLED device in a thickness direction of the flexible display panel overlaps one of the color filter layers, and each color filter layer is configured to transmit light emitted by the OLED device corresponding to the color filter layer.

2. The flexible display panel according to claim 1, wherein
the flexible display panel comprises a first touch layer and a second touch layer; and
the quantity of organic layers is 2, the organic layers comprise a first organic layer and a second organic layer, the first organic layer covers the encapsulation layer, the second organic layer covers the first organic layer and the first touch layer, the second touch layer, the plurality of color filter layers, and the first black matrix are all formed on the second organic layer, and the first black matrix covers the second touch layer.

3. The flexible display panel according to claim 2, wherein
the first touch layer is formed on the first organic layer.

4. The flexible display panel according to claim 3, wherein
the flexible display panel comprises a second black matrix, the second black matrix is formed on the encapsulation layer, the first organic layer further covers the second black matrix, and a projection of the first black matrix in the thickness direction of the flexible display panel overlaps the second black matrix.

5. The flexible display panel according to claim 2, wherein
the flexible display panel comprises a second black matrix, the second black matrix is formed on the first organic layer, the first touch layer is formed on the second black matrix, and the second organic layer further covers the second black matrix.

6. The flexible display panel according to claim 1, wherein
the quantity of organic layers is 1; and
the flexible display panel comprises a second black matrix, a first touch layer, and a second touch layer, the second black matrix is formed on the encapsulation layer, the first touch layer is formed on the second black matrix, the organic layer further covers the second black matrix and the first touch layer, the second touch layer is formed on the organic layer, the first black matrix covers the second touch layer, and a projection of the first black matrix in the thickness direction of the flexible display panel overlaps the second black matrix.

7. The flexible display panel according to claim 1, wherein
the quantity of organic layers is 1; and
the flexible display panel comprises a second black matrix and a first touch layer, the second black matrix is formed on the encapsulation layer, the first touch layer is formed on the second black matrix, the organic layer further covers the second black matrix and the first touch layer, a projection of the first black matrix in the thickness direction of the flexible display panel overlaps the second black matrix, and the first black matrix is used as a second touch layer.

8. A flexible display panel, wherein
the flexible display panel comprises a plurality of OLED devices, an encapsulation layer, a plurality of color filter layers, and a first black matrix;
the encapsulation layer covers the plurality of OLED devices; and
the plurality of color filter layers and the first black matrix are all formed on the encapsulation layer, two adjacent color filter layers are separated by the first black matrix, a projection of each OLED device in a thickness direction of the flexible display panel overlaps one of the color filter layers, and each color filter layer is configured to transmit light emitted by the OLED device corresponding to the color filter layer.

9. The flexible display panel according to claim 8, wherein
the flexible display panel comprises a first organic layer, a first touch layer, a second organic layer, a second touch layer, and a second black matrix, the first organic layer covers the encapsulation layer, the plurality of color filter layers, and the first black matrix, the first touch layer is formed on the first organic layer, the second organic layer covers the first organic layer and the first touch layer, the second touch layer and the second black matrix are both formed on the second organic layer, the second black matrix covers the second touch layer, and a projection of the second black matrix in the thickness direction of the flexible display panel overlaps the first black matrix.

10. The flexible display panel according to claim 8, wherein
the flexible display panel comprises a first touch layer, an organic layer, and a second black matrix, the first touch layer is formed on the first black matrix, the organic layer covers the encapsulation layer, the plurality of color filter layers, the first touch layer, and the first black matrix, the second black matrix is formed on the organic layer, a projection of the second black matrix in the thickness direction of the flexible display panel overlaps the first black matrix, and the second black matrix is used as a second touch layer.

11. A flexible display panel, wherein
the flexible display panel comprises a plurality of OLED devices, an encapsulation layer, an organic layer, and a plurality of color filter layers;
the encapsulation layer covers the plurality of OLED devices;
the organic layer covers the encapsulation layer, the organic layer has a plurality of holes, and a projection of one of the OLED devices in a thickness direction of the flexible display panel correspondingly falls into one of the holes; and
the plurality of color filter layers are all formed on the organic layer, each color filter layer is correspondingly filled in one of the holes, and each color filter layer is configured to transmit light emitted by the OLED device corresponding to the color filter layer.

12. The flexible display panel according to claim 11, wherein
the organic layer comprises a first organic layer and a second organic layer, the first organic layer covers the encapsulation layer, the second organic layer covers the first organic layer, and the hole is provided on the second organic layer.

13. The flexible display panel according to claim 11, wherein
the organic layer comprises a first organic layer and a second organic layer, the first organic layer covers the encapsulation layer, the hole is provided on the first organic layer, and the second organic layer covers the first organic layer and is located on an outer periphery of the hole.

14. The flexible display panel according to claim 12 or 13, wherein
the flexible display panel comprises a black matrix, the black matrix is formed on the second organic layer and is located on the outer periphery of the hole, and two adjacent color filter layers are separated by the black matrix.

15. The flexible display panel according to claim 14, wherein
the flexible display panel comprises a first touch layer and a second touch layer, the first touch layer is formed on the first organic layer, the second organic layer further covers the first touch layer, the second touch layer is formed on the second organic layer, and the black matrix covers the second touch layer.

16. The flexible display panel according to claim 12 or 13, wherein
adjacent parts of every two adjacent color filter layers are stacked together.

17. The flexible display panel according to claim 16, wherein
the flexible display panel comprises a first touch layer and a second touch layer, the first touch layer is formed on the first organic layer, the second organic layer further covers the first touch layer, the second touch layer is formed on the second organic layer, and the stacked parts of every two adjacent color filter layers cover the second touch layer.

18. The flexible display panel according to claim 14, wherein
the flexible display panel comprises a pixel define layer and a first optical structure, two adjacent OLED devices are separated by the pixel define layer, the first optical structure is formed on the pixel define layer, the encapsulation layer further covers the pixel define layer and the first optical structure, and the first optical structure is configured to reflect, to the black matrix, external light incident through the color filter layer.

19. The flexible display panel according to claim 14, wherein
the flexible display panel comprises a second optical structure, the second optical structure is formed on the encapsulation layer, the first organic layer further covers the second optical structure, and the second optical structure is configured to reflect, to the outside of the flexible display panel, light emitted by the OLED device to the black matrix.

20. The flexible display panel according to claim 19, wherein
a refractive index of the second optical structure is less than a refractive index of the first organic layer.

21. A flexible display panel, wherein
the flexible display panel comprises a plurality of OLED devices, an encapsulation layer, and a plurality of color filter layers;
the encapsulation layer covers the plurality of OLED devices; and
the plurality of color filter layers are located inside the encapsulation layer, a projection of each OLED device in a thickness direction of the flexible display panel overlaps one of the color filter layers, and each color filter layer is configured to transmit light emitted by the OLED device corresponding to the color filter layer.

22. The flexible display panel according to claim 21, wherein
the encapsulation layer comprises a first inorganic layer, an encapsulation organic layer, and a second inorganic layer, the first inorganic layer covers the plurality of OLED devices, the plurality of color filter layers are formed on the first inorganic layer, the encapsulation organic layer covers the first inorganic layer and the plurality of color filter layers, and the second inorganic layer covers the encapsulation organic layer.

23. The flexible display panel according to claim 21 or 22, wherein
the flexible display panel comprises a first black matrix, the first black matrix is located inside the encapsulation layer and adjacent to the color filter layer, and two adjacent color filter layers are separated by the first black matrix.

24. The flexible display panel according to claim 21 or 22, wherein
adjacent parts of every two adjacent color filter layers are stacked together.

25. The flexible display panel according to claim 21 or 22, wherein
the flexible display panel comprises a first organic layer, a first touch layer, a second organic layer, a second touch layer, and a second black matrix, the first organic layer covers the encapsulation layer, the first touch layer is formed on the first organic layer, the second organic layer covers the first organic layer and the first touch layer, the second touch layer and the second black matrix are both formed on the second organic layer, and the second black matrix covers the second touch layer.

26. An electronic device, wherein
the electronic device comprises a cover plate and the flexible display panel according to any one of claims 1 to 25, and the cover plate is attached to the flexible display panel.
